# EUROPEAN PATENT APPLICATION

(11) **EP 1 684 371 A1**
(43) Date of publication of application: **26.07.2006**
(21) Application number: 06075101.3
(22) Date of filing: 17.01.2006
(51) Int. Cl.: H01M 8/02, C23C 8/10, C23C 14/08

(54) **Metal alloys for forming conductive oxide coatings for electrical contacts**

(30) Priority: 20.01.2005 US 39579
(71) Applicant: Delphi Technologies, Inc., Troy, MI 48007 (US)
(72) Inventor: Eddy, David Sturge, Washington MI 48095 (US); Aukland, Neil R., Sterling Heights MI 48310 (US); Mantese, Joseph V., Shelby Township MI 48315 (US); Wang, Su-chee Simon, Troy MI 48098 (US); Thompson, Margarita, Livonia MI 48154 (US)
(74) Representative: Denton, Michael John

(57) **Abstract**

Described is a metal alloy comprising at least two metal elements which are not precious metals, said alloy being capable of forming a surface metal oxide layer that is conductive having a contact resistivity of 100 Ωcm or less after the alloy has been subjected to 125°C for 1008 hours.
Also described is a process of preparing a metal alloy providing two metal elements which are not precious metals and oxidizing the metal alloy to produce a surface metal oxide layer that is conductive having a contact resistivity of 100 Ω-cm or less after the alloy has been subjected to 125°C for 1008 hours.

## Description

### TECHNICAL FIELD

The present invention relates to conductive materials; more particularly, to such materials useful in forming high-conductivity, durable electrical contacts; and most particularly, to such materials which are not noble metals and which form passivating yet conductive surface oxides.

### BACKGROUND OF THE INVENTION

Many useful articles of manufacture, such as proton exchange membranes (PEM) fuel cells, contain parts that are brought into contact to form an electrical circuit. The parts have contacting surfaces, commonly referred to as electrical contacts, between which electrical current continuity must be maintained. The material of these electrical contacts must remain electrically conductive through out operation of the article. The electrical connection between electrical contacts must be continuous especially in oxidative environments to ensure suitable operation of the connected electrical circuitry of the articles.

Electrical contacts often have an inexpensive base metal or substrate made of, for example, copper, nickel, or titanium. These base materials, however, are problematic when exposed to highly oxidative environments. Such base metals will typically corrode or form electrically-resistive oxide layers on the base metal. The electrically-resistive oxide layers significantly reduces the conductivity of the base metal.

It has been known to plate tin, silver or noble metals including gold, platinum and palladium on contact base metals to mitigate the effects of oxidation. Tin is an attractive plating material because it is both inexpensive and it forms a continuous oxide layer, on the order of 5 nm, which acts as a barrier to further oxidation and which is easily penetrated during electrical contact assembly. The oxides of silver are inherently soft and are easily displaced in sliding contacts. Gold, platinum and palladium do not form stable native oxides at near room temperature and, thus, are excellent materials for electrical contacts. The precious metals are, however, costly which prevents their wide use in electrical contact or terminal applications.

What is needed is a metal alloy or a class of metal alloys that naturally form electrically conductive layers on the metal alloy even upon oxidation and are simple, cost-effective and useful for maintaining electrical conductivity of electrical contacts in ambient or treated environments.

It is a principal object of the present invention to provide improved materials for coating electrical contacts which are simple, inexpensive to manufacture, and which maintain acceptable electrical conductivity of the contact during use.

### SUMMARY OF THE INVENTION

An embodiment of the invention is a metal alloy comprising at least two metal elements which are not precious metals, said alloy being capable of forming a surface metal oxide layer that is conductive having a contact resistivity of 100 Ωcm or less after the alloy has been subjected to 125°C for 1008 hours.

Another embodiment of the invention is an electrical contact for use in an electromechanical apparatus comprising at least two metal elements which are not precious metals, said alloy being capable of forming a surface metal oxide layer that is conductive having a contact resistivity of 100 mΩ or less after the alloy has been subjected to 125°C for 1008 hours.

Another embodiment is a bipolar plate for use in a fuel cell state comprising a metal alloy comprising at least two metal elements which are not precious metals, said alloy being capable of forming a surface metal oxide layer that is conductive having a contact resistivity of 100 mΩ or less after the alloy has been subjected to 125°C for 1008 hours.

Another embodiment is a method of forming a bipolar plate for use in a fuel cell assembly, comprising: (a) forming a substrate blank of said bipolar plate from a conductive metal; and (b) depositing a layer on at least one surface of the blank, the layer comprising a metal alloy comprising at least two metal elements, said alloy being capable of forming a surface metal oxide layer that is conductive having a contact resistivity of 100 mΩ or less after the alloy has been subjected to 125°C for 1008 hours.

Another embodiment is a process of preparing a metal alloy providing two metal elements which are not precious metals and oxidizing the metal alloy to produce a surface metal oxide layer that is conductive having a contact resistivity of 100 Ω-cm or less after the alloy has been subjected to 125°C for 1008 hours.

### BRIEF DESCRIPTION OF THE DRAWINGS

These and other objects, features and advantages of the present invention be apparent from the following detailed description of the embodiments, appended claims and accompanying drawings in which:
FIG. 1 is a schematic cross-sectional view of a portion of a PEM fuel cell stack showing the relationship of bipolar plates formed in accordance with the invention to the anodes and cathodes thereof;
FIG. 2 is a schematic cross-sectional view of a bipolar plate in accordance with the invention;
FIG. 3 is a schematic cross-sectional view of a prior art apparatus having mating first and second electrical contacts;
FIGS. 4a and 4b are schematic cross-sectional views of a metal alloy in accordance with the invention without and with, respectively, conductive metal oxide surface layers formed either naturally or as induced by a processing step;
FIG. 5 is a schematic phase diagram of a binary alloy (although ternary and quaternary and higher order phase diagrams may equally apply) showing a region wherein a solid solution of metals exists;
FIG. 6 is a schematic phase diagram of a binary metal oxide (although ternary and quaternary and higher order phase diagrams may equally apply) showing a region wherein a solid solution of metal oxides exists;
FIG. 7 is a graph of force versus contact resistance, showing the contact resistance of a metal alloy in accordance with the invention, before and after oxidation, as a function of force applied to the contact interface;
FIGS. 8 and 9 are schematic drawings of a lattice of metal ions in accordance with the invention, showing how the ionic valence states result in electrical conductivity;
FIG. 10 is a line graph showing rapid formation of a passivating oxide layer by cyclic voltammetry;
FIG. 11 is a schematic representation of the formation of an atomic layer of cupric oxide formed on the surface of cuprous oxide which is formed on the surface of a copper base metal;
FIG. 12 is a graph showing the contact resistance of copper measured as a function of load after an oxide has formed on the copper metal that was kept at 125°C for 1008 hours;
FIG. 13 is a graph showing the maximum desirable oxide resistivity of the metal alloy as a function of its thickness;
FIG. 14 is a schematic representation of the elements of a copper alloy that forms a conductive oxide layer that prevent the formation of cuprous oxide;
FIG. 15 is a schematic representation of a network of conductive veins formed through out a cuprous oxide matrix; and
FIG. 16 is a binary phase diagram for Cu-Cr.

### DESCRIPTION OF THE PREFERRED EMBODIMENTS

### Definitions:

Polaron hopping: means the movement of an electron where it is an electron in a crystal lattice together with a cloud of phonons that result from the deformation of the lattice produced by the interaction of the electron with ions or atoms in the lattice.

Passivate: means growth of an oxide coating on a metal alloy surface to reduce the chemical reactivity of the metal or alloy surface.

Conductive veins: means a network of electrically conductive veins located in a high resistivity material.

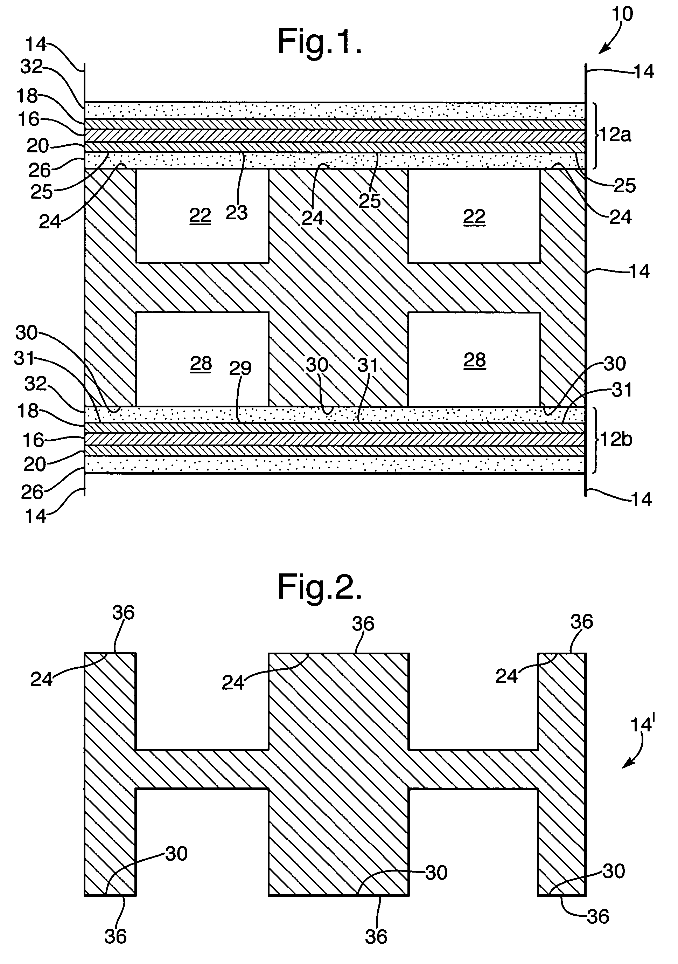

Referring now to the drawings, FIG. 1 is a portion 10 of a multiple-cell PEM fuel cell stack that includes a first fuel cell unit 12a and a second fuel cell unit 12b, separated and mechanically/electrically connected by a bipolar plate 14. Each fuel cell 12a, 12b comprises a proton exchange membrane 16 separating an anode 18 and a cathode 20 in known fashion. A complete fuel cell stack (not shown) comprises a plurality of fuel cells 12 similarly separated and connected by a plurality of bipolar plates 14.

Each bipolar plate 14 is provided with a first set of channels 22 for providing oxygen, typically in the form of air, to the cathode surface 23. Channels 22 are separated by first lands 24 for making mechanical and electrical contact with cathode 20. Optionally, a conductive cathode diffuser 26 may be provided between cathode 20 and bipolar plate 14 to permit air to diffuse laterally and thereby reach those portions 25 of the cathode surface 23 covered by first lands 24.

Each bipolar plate 14 is provided with a second set of channels 28 for providing hydrogen fuel to the anode surface 29. Channels 28 are separated by second lands 30 for making mechanical and electrical contact with anode 18. Optionally, a conductive anode diffuser 32 may be provided between anode 18 and bipolar plate 14 to permit fuel to diffuse laterally and thereby reach those portions 31 of the anode surface 29 covered by second lands 30.

It should be understood that in an actual bipolar plate, air and fuel channels 22 and 28 may be oriented orthogonally of each other.

Referring to FIG. 2, surface portions of lands 24, 30 of improved bipolar plate 14' include pure metals, metal alloys, or metallic compounds which may be oxidized to form surface passivation oxide layers having high electrical conductivity, defined by a surface resistivity less than about 0.007 Ω-cm² and preferably less than about 0.0035 Ω-cm² or less. By contrast, the comparable surface resistivity of surface-oxidized pure titanium is about 0.035 Ω-cm². Thus, oxide passivation layers formed in accordance with a first embodiment of the invention provide a conductivity improvement on the order of about ten-fold or greater. Examples of suitable metals and alloy systems include, but are not limited to, Ti--Nb, Ti--Ta, La--Sr--Cr, and La--Sr--Co.

In a currently preferred embodiment, contact surfaces of lands 24, 30 of a bipolar plate substrate 14' (formed of preferably aluminum or stainless steel) comprise a thin outer layer 36 of an alloy comprising between about 0 and about 3 atomic percent Nb or Ta and between about 97 and about 100 atomic percent Ti; most preferably, 1.5 atomic percent Nb or Ta and 98.5 atomic percent Ti. Such a layer is readily formed by any of several known methods, for example, by magnetron sputtering of Ti, Nb and Ta targets onto substrate 34, and can form an oxide layer having a surface resistivity of about 0.0035 Ω-cm².

Preferably, layer 36 is subsequently treated thermally, chemically, and/or electrochemically in known fashion during manufacture of bipolar plate 14 to cause a portion of the metallic constituents of layer 36 to be converted to metal-like electrically-conductive oxides, for example, Ti⁺³ₓTi⁺⁴₍₁₋ₓ₎Nb⁺⁵ₓO₂ or Ti⁺³ₓTi⁺⁴₍₁₋ₓ₎Ta⁺⁵ₓO₂ where x represents the mole fraction of Nb or Ta, typically but not limited to the range of 0.0 ≤ x ≤ 0.03. Alternatively, bipolar plate 14' containing layer 36 may be assembled into a fuel cell stack and layer 36 may be allowed to oxidize spontaneously by exposure to atmospheric oxygen and electrical current during operation of the fuel cell.

The provided alloy can have the oxide formation occur by subjecting the alloy to a thermally oxidizing or reducing atmosphere, treatment with microwaves, electronic beams, x-rays, chemical treatments in an oxidizing or reducing environment, and the like.

In a second embodiment of the invention, most or all of bipolar plate 14' is formed of metal material as recited hereinabove, the surfaces thereof then being oxidized to form layers 36.

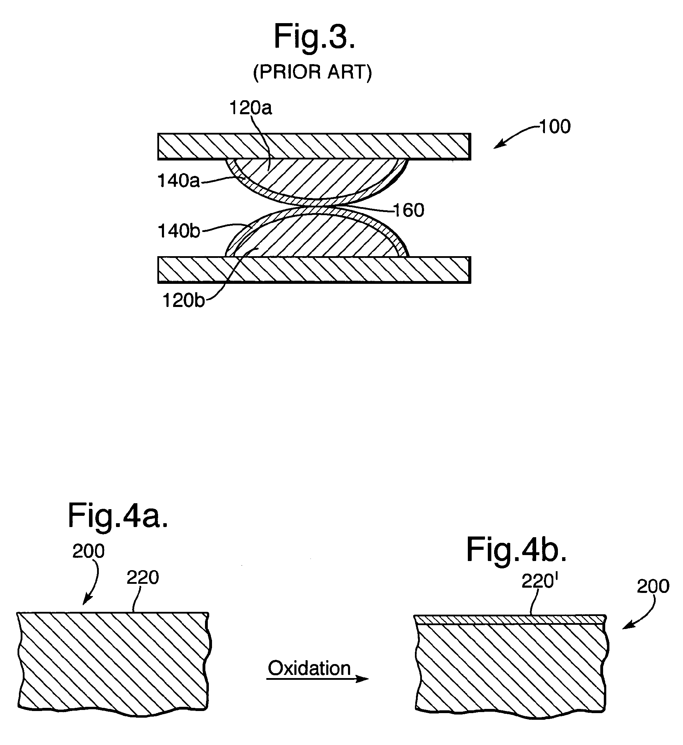

FIG. 3 illustrates a prior art electromechanical apparatus 100 that includes a first electrical contact element 120a and a second electrical contact element 120b, shown in mechanical and electrical contact along respective surfaces to form an electrical interface 160. Elements 120a, 120b are brought into and out of mechanical contact by known means (not shown) to make or break electrical connection therebetween. The prior art materials of which contact elements 120a and 120b typically are formed are known to be susceptible to oxidation to form surface oxide layers 140a, 140b that are non-conductive.

Referring to FIGS. 4a and 4b, a blank 200 comprising an alloy in accordance with a third embodiment of the invention has a free surface 220 available for oxidation to form a surface oxide layer 220' having a conductance of, preferably, less than about 0.0015 Ωcm². When such alloys are substituted into apparatus 100 for forming elements 120a, 120b, the resulting surface oxide layers 140a, 140b are conductive. In electrical contacts in accordance with the invention, conductive oxide layers of the alloys may be formed in situ before or after assembly of the electrical contacts, or may be provided in an oxidative step during manufacture of a contact-containing electromechanical apparatus.

Materials exhibiting passivating conductive oxide layers, suitable for forming contact elements 120a, 120b and surface oxide layers 140a, 140b in accordance with the invention have at least two metals from one or more of Periodic Table of Elements group IA, IB, IIA, IIB, IIIA, IIIB, IVA, IVB, VA, VB, VIA, VIB, VIIA or VIIB and are not precious metals. (See Handbook of Chemistry & Physics 76^{th} Edition (1995-1996) Lide et al, published by CRC Press, inside front cover). The alloys may be selected from the metal alloy group (number in parenthesis is Periodic Table of Elements Group Number) consisting of chemical elements having the following elemental symbols: Y(3)-Ba(2)-Cu(11); La(3)-Sr(2)-Co(9); La(3)-Sr(2)-Cr(6); La(3)-Sr(3)-V(5); La(3)-Ca(2)-Mn(7); La(3)-Sr(2)-Mn(7); La(3)-Nd(3)-Ni(10); Ti(13)-Ta(5); Ti(13)-Nb(5); Ti(13)-V(5); Ti(13)-W(6); Ti(13)-Mo(6); Ti(13)-Zr(4)-Ta(5); Ti(13)-Zr(4)-Nb(5); Cr(6)-Ta(5); Cr(6)-Nb(5); Cr(6)-Ti(13); Cr(6)-Zr(4); Sr(2)-V(5); Ni(10)-Li(1); Cu(11)-Ti(13); Cu(11)-Fe(8); Cu(11)-Mn(7); Cu(11)-Al(13); Cu(11)-Si(14); Sn(14)-Sb(15); and Sn(14)-In(13). Preferred alloys are valve metal alloys, including copper valve metal alloys, as well as copper-gallium or copper-tin alloys and the like. Suitable valve metals are titanium, tungsten, chromium, aluminum, zirconium, hafnium, vanadium, niobium, tantalum, bismuth, antimony and mixtures, and alloys.

To further illustrate the manufacture, composition, and benefit of alloys and oxides in accordance with the third embodiment of the present invention, the following discussion deals specifically with some alloys of the present invention having titanium (Ti) as the main metal component.

In nature, pure Ti forms a passivating TiO₂ layer when exposed to atmospheric oxygen which prevents further corrosion of the plate. Unfortunately, this layer acts as an electrical insulator and therefore limits current flow; however, TiO₂ can be made conductive by doping with approximately 1 atom percent (at.%) tantalum (Ta) or niobium (Nb).

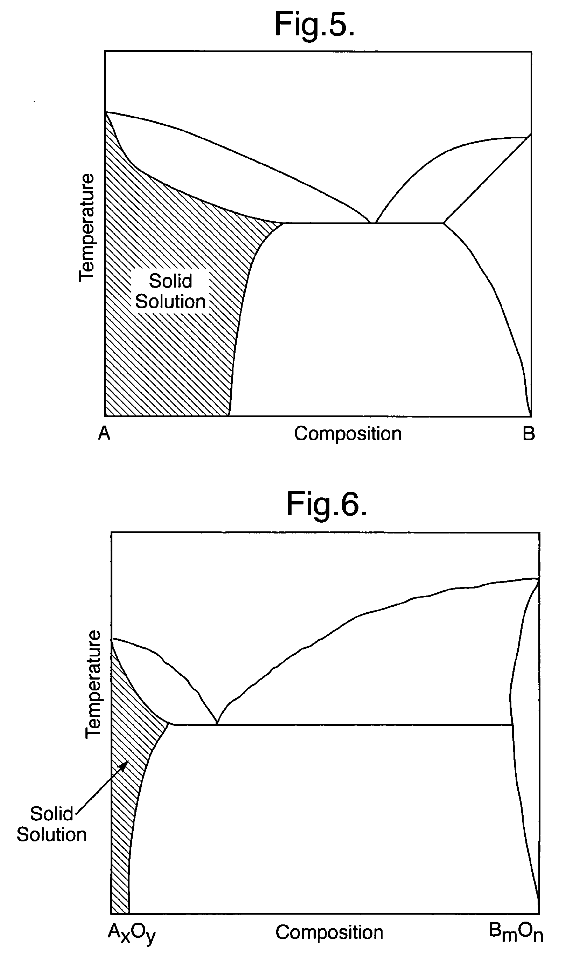

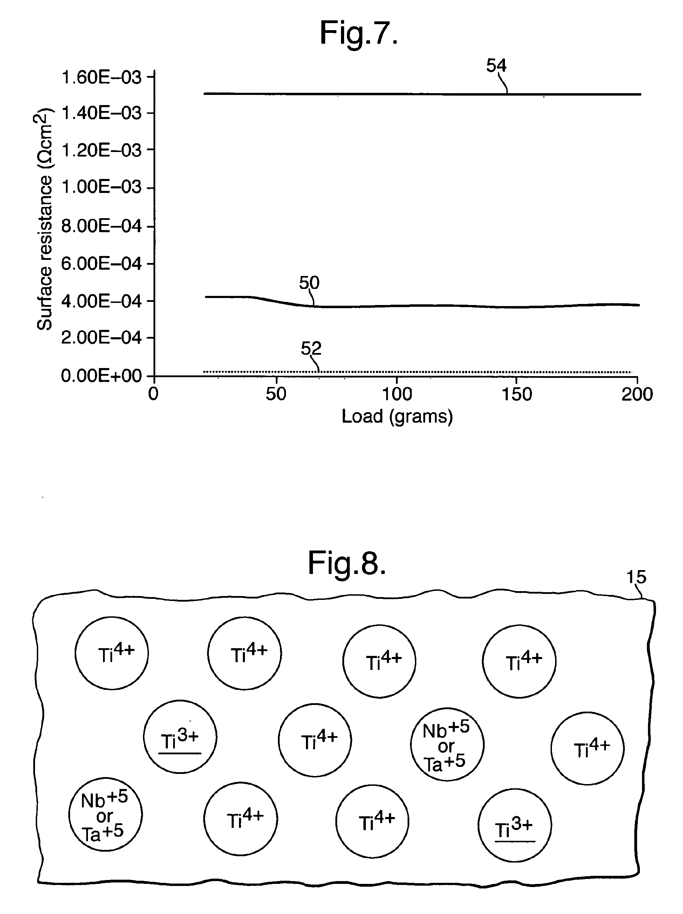

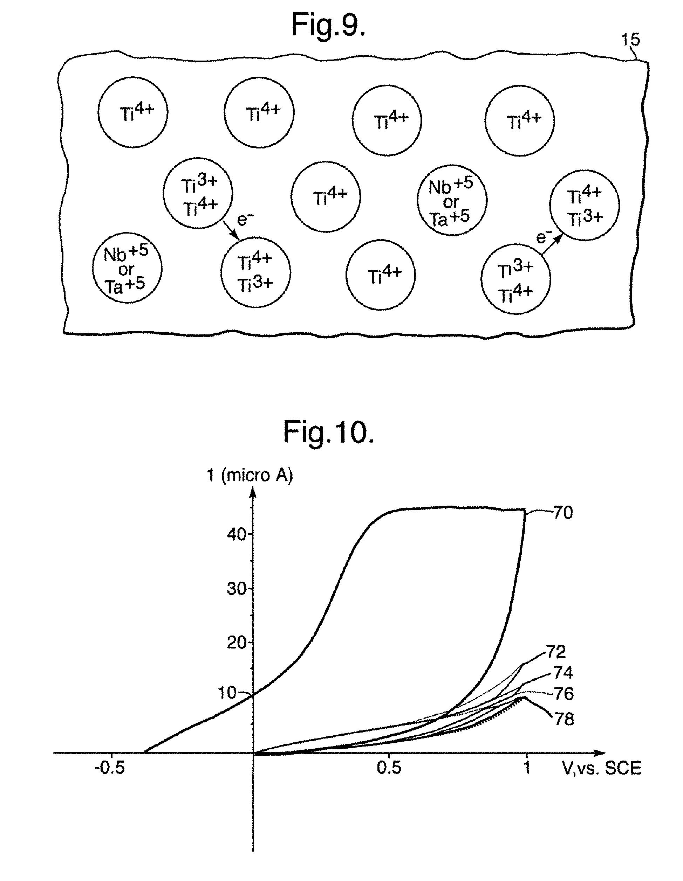

In the Ti example, for doping to be successful in producing metal alloys that can form oxides which are both passivating and conductive, it is believed to be helpful to consider the following:
(1) To achieve n-type doping the doping ion should be in a higher valence state than the main metal ion; e.g, Ti⁺⁴ may be doped by Nb⁺⁵ or Ta⁺⁵, as shown in alloy surface layer 15 in FIGS. 8 and 9. Thus, it is believed that to preserve electroneutrality in the oxide, some of the Ti⁺⁴ ions are forced into the Ti⁺³ state. Electrons then hop between Ti⁺³ and Ti⁺⁴ ions, as shown in alloy surface layer 15 in FIG. 9 , resulting in electrical conductivity. P-type doping can be achieved by adding dopants that can occur in oxidation state of (3+) or lower.
(2) The main metal cations in the oxide lattice (e.g., Ti⁺⁴) and the lower valence cations (e.g., Ti⁺³) should have similar ionic radii, preferably within about 20%; otherwise, the smaller ions will tend to segregate as intersticial defects, which will ultimately interfere with the hopping conduction. Likewise, it is important that the doping ion truly substitute for the main ion and not segregate as an interstitial defect; therefore, the ionic radii of Ti⁺⁴ and the dopant ion should be similar and preferably within about 20%, as shown below in Table I for Ti, Nb, and Ta.
(3) The doping element should form a solid solution with the main element, rather than a compound, so that the doping atoms do not phase separate from the main metal atoms but remain uniformly distributed throughout the alloy. Phase diagrams of Ti-Nb and Ti-Ta indicate that alloys of Ti with about 0 to about 100 at.% of either Nb or Ta, preferably about 1 to 10 at.%, form such solid solutions. A schematic phase diagram typical for alloys of metals A and B is shown as FIG. 5.
(4) The conductive passivating oxides to be formed should also form solid solutions without phase separation, which would result in formation of separate, highly non-conductive regions dominated by the properties of the single component oxides, which regions would be highly non-conductive. Phase diagrams, like the schematic metal oxide phase diagram shown in FIG. 6, indicate that both the TiO₂-Nb₂O₅ and TiO₂-Ta₂O₅ systems form solid solutions of metal oxides.

**Table I, Ionic Radii of Titanium Ions and Exemplary Titanium Dopants**

| Ion | Ionic Radius (Å) |
|---|---|
| Ti⁺³ | 0.76 |
| Ti⁺⁴ | 0.68 |
| Nb⁺⁵ | 0.69 |
| Ta⁺⁵ | 0.68 |

Alloys of either Nb and Ta meet all four of the above criteria when the dopant is added to Ti in the dopant range of about 1 at.% to about 50 at.%, preferably between about 1 and about 10 at.%.

In order to form a conductive passivating surface layer on an electrode formed of a Ti alloy, the surface atoms may be oxidized, preferably by controlled electro-oxidation. A currently preferred means for providing such oxidation is via cyclic voltammetry (CV), although obviously other oxidation methods as may occur to one of skill in the art are fully comprehended within the scope of the present invention. Since the composition of corrosive fluid which accumulates in a PEM fuel cell assembly is known, oxidation of an alloy in such a fluid can produce an oxide surface film which is both conductive and passivating to further oxidation by the fluid, thereby providing long-term service in such a fuel cell assembly.

One satisfactory CV oxidation method includes the steps of:
(a) forming 1073 ml of an aqueous electrolyte solution containing 2 ml 490 ppm HF, 0.56 ml 980 ppm H₂SO₄, and 7 g Na₂SO₄ in deionized water;
(b) mounting in the solution a working electrode formed of the alloy to be oxidized, a graphite counter-electrode, and a Calomel reference electrode;
(c) heating the electrolyte solution to 80°C for 15 minutes while bubbling oxygen through the solution and monitoring the open circuit potential (OCV) between the working electrode and the reference electrode; and
(d) ramping the potential from the OCP up to 1 volt and then down to 0, preferably at a scan rate of about 5 mV/sec.

Additional ramping cycles may be imposed; however, as shown in FIG. 10, a high current flow is obtained in the first cycle 70 but not in four subsequent cycles 72,74,76,78, indicating that a passivating film is formed in the very first cycle 70. This film may have a thickness of about 100 Å. The electrical resistance of the passivating layer is about 80-100 times greater than that of the non-oxidized alloy, but as shown in Table II it is within the desired upper limit of 0.0015 Ωcm².

**Table II: Surface Resistance of Ti Alloy Oxides (5 CV Cycles)**

| Percent Dopant | Surface Resistance (Ωcm²) |
|---|---|
| 1% Ta | 0.0001 |
| 3% Ta | 0.00025 |
| 1% Nb | 0.00081 |
| 1.5% Nb | 0.00008 |
| 3% Nb | 0.00015 |

Working load can affect the stability and conductivity of electrical connections. FIG. 7 shows the effect of load to be negligible on a surface oxide layer (line 50) in accordance with the invention, as well as on the bare metal surface (line 52) from which was formed, and a prior art passivated metal surface (line 54).

Another embodiment of the present invention provides metal alloys for base metals that naturally form electrically conductive native oxides without having to coat or electroplate conductive layers of expensive metals, such as tin or gold, on the surface of the base material. The alloys exhibiting suitable conductive oxide layers for electrical contacts 120a, 120b and surface oxide layers 140a and 140b, as shown in FIG. 3, are selected from the following group of materials: Y-Ba-Cu; La-Sr-Co; La-Sr-Cr; La-Sr-V; La-Ca-Mn; La-Sr-Mn; La-Nd-Ni; La-Ba-Mn; Ti-Ta; Ti-Nb; Ti-V; Ti-W; Ti-Mo; Ti-Zr-Ta; Ti-Zr-Nb; Cr-Ta; Cr-Nb; Cr-Ti; Cr-Zr; Sr-V; Cu-Ge; Cu-Sn; Cu-Ti; Cu-Fe; Cu-Mn; Cu-Sb; Cu-Ti-Ta; Cu-Ti-Nb; Cu-Sn-Sb; Sn-Sb; Sn-In; Sn-Ta; Sn-P; Ni-La; Ni-Li; Cu-In; Cu-Si and Cu-Al.

To further illustrate the manufacture, composition, and benefit of the metal alloys of the above embodiment of the present invention, the following discussion deals specifically with some alloys of the present invention having copper (Cu) as the main metal component.

In general, copper is an excellent conductor of heat and electricity and is often alloyed with other elements to yield materials that have greater hardness and improved yield strength. Copper alloys are widely employed in the electrical industry as the substrate or base material for electrical contacts. Such copper alloys effectively produce oxides electrical conductivities with several orders of magnitude greater than base metal oxides.

Copper forms two oxides in air: cuprous (Cu₂O) oxide or cupric (CuO) oxide. Both are semiconductors having band gaps of 2.1 and 1.3 eV, respectively. At ambient temperatures and pressures, each copper atom donates a single electron to its neighboring oxygen atom resulting in the formation of the simple cubic Cu₂O structure with four copper and two oxygen ions per unit cell.

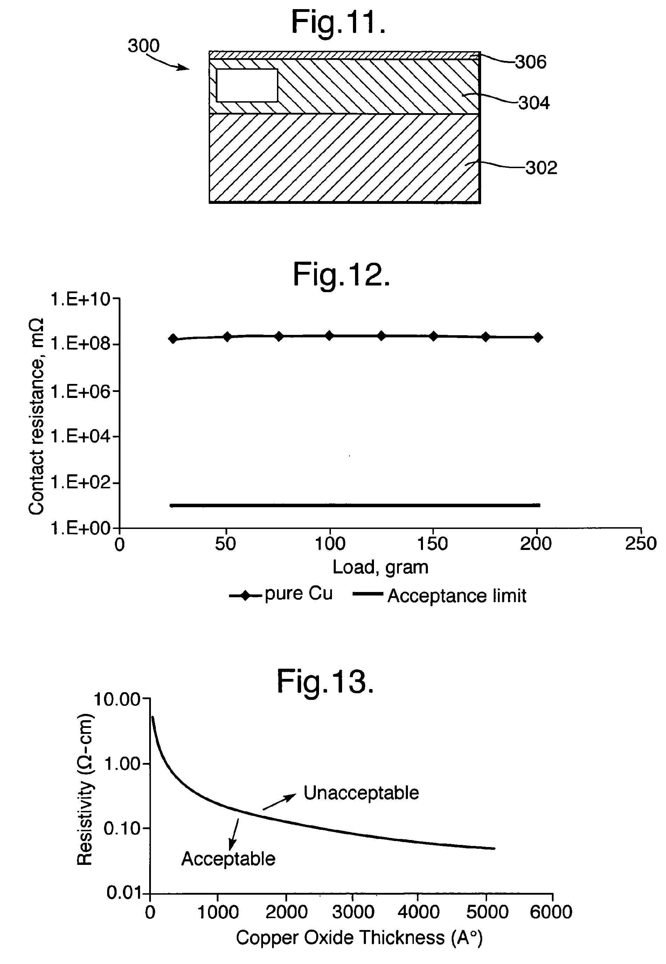

As shown in FIG. 11, a natural deficiency of Cu⁺ exists in the Cu₂O layer creating a vacancy in the molecular structure of an electrical contact 300. Cu⁺ cations diffuse from the base copper metal layer 302, through the vacancies of a Cu₂O layer 304 towards an air/oxide interface, where they react with oxygen to form additional oxide. In this manner the Cu₂O layer 304 continues to grow on the Cu base metal layer 302, reaching a thickness on the order of 5 nm after long-term ambient air exposure. The higher partial pressure of oxygen at the air/oxide interface, a CuO layer 306 forms as one to two monolayers of the oxide on top of the Cu₂O layer 304. Thus an oxide semiconductor interface primarily composed of Cu₂O is nearly almost always interposed between two mating copper contacts. With prolong exposure at severely elevated temperatures, this oxide can reach thicknesses on the order of 2000 Å (200 nm).

Despite the existence of cation vacancies in the Cu₂O layer 304 (which gives rise to p-type conduction), its inherently low carrier density results in a large contact resistance to the underlying copper metal. FIG. 12 demonstrates the effects of keeping copper in air at 125 °C for 1008 hours, a test commonly referred to as the Packard test. As shown, the contact resistance of the copper is quite substantial, showing a resistivity of about 1x10⁸ mΩ or more. Normally, under the conditions of the Packard test, a material having a contact resistance of 100 mΩ or less is desirable for applications.

Acceptable levels of electrical resistivity based on the Packard standard test configuration of 100g load applied to a gold stylus is shown in FIG. 13. The load gives rise to a known contact area of approximately 2.5 x 10-4 cm². The maximum permissible oxide resistivity can be calculated to yield a 100 mΩ contact resistance, for various oxide thicknesses as presented in FIG. 13. As shown, for an oxide thickness of 200 Å (typical of what can be expected on copper after prolonged oxidation at approximately 100 °C), the maximum allowable oxide resistivity is 1.25 Ω-cm.

Several mechanisms are available that form a conductive oxide layer on the base material of the electrical contact or terminal. One way in which the electrical conductivity of Cu₂O may be improved is by adding an impurity to the copper, often referred to as doping, which becomes incorporated into the Cu₂O structure during oxidation. The impurity element substitutes either the Cu⁺ or O⁻² ions to create an impurity band within kT (k is Boltzman's constant and T the temperature in degrees Kelvin, with kT of about 0.026 eV at 300 K) of the conduction band (donors) or just above the valence band (acceptors). Given that Cu₂O is naturally a p-type conductor, it is preferable to add acceptors. Otherwise, donor ions must first compensate the intrinsic acceptors before increasing the number of conduction band electrons. Considerations for selecting a suitable dopant are as follows:
(1) To ensure that the doping element is naturally incorporated into the oxide when formed under ambient conditions, it is desirable that the alloying element remains uniformly dispersed in the melt state. Therefore, one seeks copper-(doping element) binary phase diagrams showing a region of solid solubility near the copper-rich phase.
(2) To dope Cu₂O n-type, one may substitute a cation of valence +2 or higher on the Cu⁺ site or alternatively anion substitution with valence of -1. P-type doping can be accomplished by substituting a -3 valence anion for O⁻². Doping may also be achieved by interstitial cations or anions, however, high mobility element may lead to ionic conduction.
(3) In selecting either cation or anion dopants, ions having ionic radii comparable or substantially similar to the host elements are best. Thus, in substituting for Cu⁺, a cation with a radius of on the order of 0.96 Å may be used, while anion substitution has a radius of about 1.4 Å. Considerable leeway, however, is permissible with this condition as long as the substituting ion is smaller than its copper oxide counterpart.
(4) To create a continuous impurity band either just above the valence band or just below the conduction band, the doping concentration needs to be sufficiently high such that the localized wave functions of the electron (n-type doping) or hole (p-type doping) overlap and the charge carriers become itinerant. Alternatively, the charge carrier may be weakly bound leading to polaron hopping conduction. It may be desired that substantial levels of impurity atoms be supplied to affect the conductivity of Cu₂O. Consequently, it is preferable that the free energies of oxide formation of dopant cations are comparable or substantially similar to the Gibbs free energy of Cu₂O, otherwise dopant segregation may occur. It is desirable that the phase diagram of the dopant oxide form a solid solution with Cu₂O near the Cu₂O-rich end of the oxide solubility phase diagram. See Table I for dopants and copper doping.

**Table I: Physical parameters for the doping of Cu₂O**

| **Ionic Radius (Å)** | **Doping Type** | **Oxide** | **Gibbs Free Energy (kJ/mol)** |
|---|---|---|---|
| 0.96 | None | Cu₂O | -146 |
| 0.53 | n-type | GeO₂ | -237 |
| 0.71 | n-type | SnO₂ | -516 |

The heat of formation for the oxides and solid solubility of the oxide phases for Ge and Sn can also be considered. The heats of formation of the oxides of Ge and Sn are relatively large compared to the heat of formation of Cu₂O.

Another consideration for suitable alloy oxides includes conduction cation diffusion barriers and conductive veins. This is a variant of the Polaron Hopping mechanism, which selects materials that phase separate in their oxide state from Cu₂O yet form electrically conductive oxides, e.g., Ru in Cu.

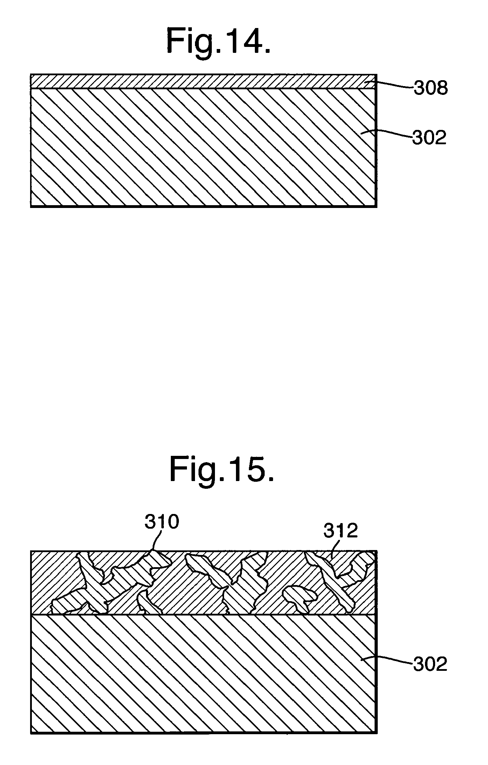

Alternatively for suitable alloy oxides one may consider ternary material systems that phase separate in their oxide state from Cu₂O and which form conductive oxides. Phase separation can take the form of either a conductive native oxide surface layer 308 on the base metal layer 302 as illustrated in FIG. 14, or a network of conductive veins 310 throughout a copper matrix of a conductive oxide layer 312 on the base metal 302 as depicted in FIG. 15.

Unlike the requirements for bulk conduction wherein one seeks phase diagrams depicting a region of solid solubility for oxides to be used, the ternary material method of conduction utilizes: (1) large differences in Gibbs free energies of the oxides of the copper and the alloying additive, or alternatively phase separation occurring in the metal phase; while simultaneously, (2) adding an additional (third) constituent which enhances the electrical conductivity of the oxide of either veinular or surface barrier materials.

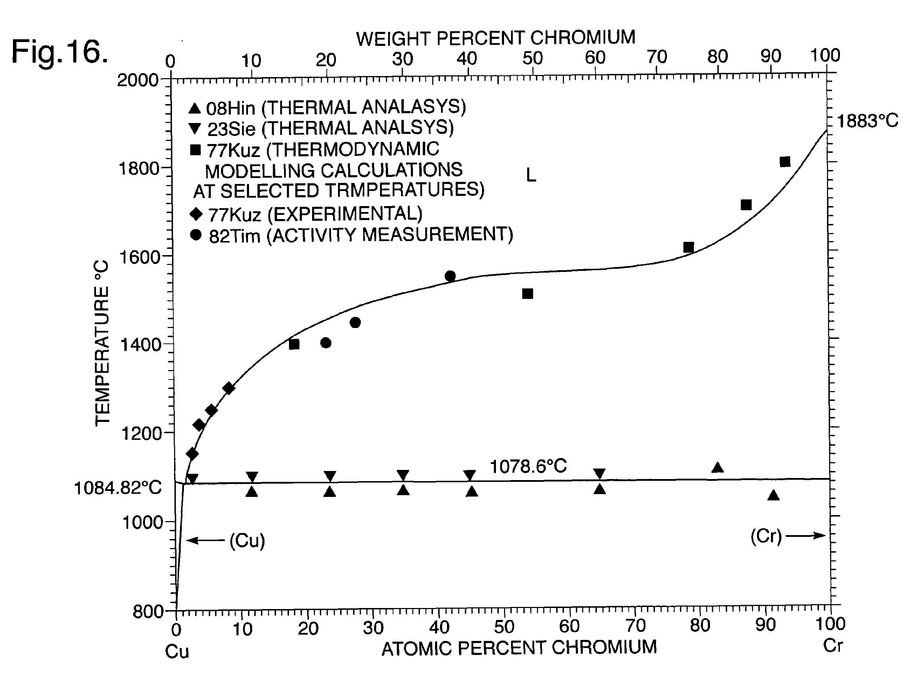

Also, the Cu-Cr binary phase diagram as shown in FIG. 16, taken from P.R. Subramanian, D.J. Chakrabarti, D.E. Laughlin, "Phase Diagrams of binary copper alloys," ASM International, Materials Park, OH, 1994 incorporated by reference, indicates that this alloy system will form veins when cast from its metal phase. Accordingly for suitable alloy oxides any conductive oxide mechanism may be utilized in such systems, including: doping, hopping, tunneling and the like.

In addition, a non-conductive alloy may be subjected to a variety of processes that may induce a mixed valance state in the material or the alloying element, that during oxidation may result in the formation of either a conductive film or the formation of conductive veins. Such processes include but are not limited to chemical treatments, such as in oxidizing or reducing environments, thermal treatments in reducing or oxidizing atmosphere, or treatments by UV light, x-rays, microwaves, e-beam, etc..

While the invention has been described by reference to various specific embodiments, it should be understood that numerous changes may be made within the spirit and scope of the inventive concepts described. Accordingly, it is intended that the invention not be limited to the described embodiments, but will have full scope defined by the language of the following claims.

## Claims

1. A metal alloy comprising at least two metal elements which are not precious metals, said alloy being capable of forming a surface metal oxide layer that is conductive having a contact resistivity of 100 Ωcm or less after the alloy has been subjected to 125°C for 1008 hours.

2. The metal alloy of claim 1 having at least two metals from one or more of Periodic Table of Elements groups IA, IB, IIA, IIB, IIIA, IIIB, IVA, IVB, VA, VB, VIA, VIB, VIIA, VIIB.

3. The metal alloy in accordance with Claim 2 selected from the group of alloys consisting of chemical elements having the symbols Cu-Ge, Cu-Sn, Cu-Ti, Cu-Fe, Cu-Sb, Cu-Ti-Ta, Cu-Ti-Nb, Cu-Sn-Sb, Sn-Sb, Sn-Ta, Sn-Nb, Ni-La, Ni-Li, Y-Ba-Cu, La-Sr-Co, La-Sr-Cr, La-Sr-V, La-Ca-Mn, La-Sr-Mn, La-Ba-Mn, La-Nd-Ni, Ti-Ta, Ti-Nb, Ti-V, Ti-W, Ti-Mo, Ti-Zr-Ta, Ti-Zr-Nb, Cr-Ta, Cr-Nb, Cr-Ti, Cr-Zr, Sr-V, Cu-Si, Cu-Al, Cu-In, and combinations thereof.

4. The metal alloy in accordance with Claim 1 wherein a first element is a base metal and at least a second element is a dopant wherein said metal alloy has a resistivity less than or equal to 100 Ω-cm or less when exposed to an oxidative environment.

5. The metal alloy in accordance with Claim 4 wherein said second element is uniformly dispersed in said first element during a melt state.

6. The metal alloy in accordance with Claim 4 wherein said second element is a higher valence state than said first element.

7. The metal alloy in accordance with Claim 4 wherein the anions of said second element is in a lower valence state than the anions of said first element.

8. The metal alloy in accordance with Claim 4 wherein the ionic radii of said second element is substantially similar to the ionic radii of said first element.

9. The metal alloy in accordance with Claim 3 wherein the Gibbs free energy of oxide formation of the metal of said second element is substantially similar to the Gibbs free energy of the oxide of said first element.

10. The metal alloy in accordance with Claim 4 wherein said first element is Cu and said second element is selected from the group consisting of Ge and Sn.

11. The metal alloy in accordance with Claim 1 wherein a first element is a base metal and a second element is a dopant, wherein said first and second elements phase separate in their oxide state and form conductive oxides.

12. The metal alloy in accordance with Claim 1 wherein a first element is a base metal, a second element is a dopant and a third element is a dopant, wherein said first, second and third elements phase separate in their oxide state and form conductive oxides.

13. The metal alloy in accordance with Claim 11 wherein said first, second and third elements phase separate into a conductive oxide surface layer.

14. The metal alloy in accordance with Claim 12 wherein said first, second and third elements phase separate into a network of conductive veins.

15. An electrical contact for use in an electromechanical apparatus comprising at least two metal elements which are not precious metals, said alloy being capable of forming a surface metal oxide layer that is conductive having a resistivity less than or equal to 100 Ω-cm or less after the alloy has been subjected to 125°C for 1008 hours.

16. The electrical contact of claim 15 having at least two metals from one or more of Periodic Table of Elements groups IA, IB, IIA, IIB, IIIA, IIIB, IVA, IVB, VA, VB, VIA, VIB, VIIA, VIIB.

17. The electrical contact in accordance with Claim 15 wherein said metal alloy is selected from the group of alloys consisting of chemical elements having the symbols Cu-Ge, Cu-Sn, Cu-Ti, Cu-Fe, Cu-Sb, Cu-Ti-Ta, Cu-Ti-Nb, Cu-Sn-Sb, Sn-Sb, Sn-Ta, Sn-Nb, Ni-La, Ni-Li, Y-Ba-Cu, La-Sr-Co, La-Sr-Cr, La-Sr-V, La-Ca-Mn, La-Sr-Mn, La-Ba-Mn, La-Nd-Ni, Ti-Ta, Ti-Nb, Ti-V, Ti-W, Ti-Mo, Ti-Zr-Ta, Ti-Zr-Nb, Cr-Ta, Cr-Nb, Cr-Ti, Cr-Zr, Sr-V, Cu-Si, Cu-Al, Cu-In, and combinations thereof.

18. The electrical contact in accordance with Claim 15 wherein a first element is a base metal and at least a second element is a dopant wherein said metal alloy has a resistivity less than or equal to 100 Ω-cm when exposed to an oxidative environment.

19. The electrical contact in accordance with Claim 15 wherein a first element is a base metal and a second element is a dopant, wherein said first and second elements phase separate in their oxide state and form conductive oxides.

20. The electrical contact in accordance with Claim 15 wherein the first element is a base metal, the second element is a dopant and a third element is a dopant, wherein said first, second and third elements phase separate in their oxide state and form conductive oxides.

21. The electrical contact in accordance with Claim 15 wherein the alloy is a base material comprised of Cu having a dopant selected from the group consisting of Ge and Sn.

22. The electrical contact of claim 21 wherein said Cu and said dopant phase separate into a network of conductive veins.

23. A process of preparing a metal alloy providing two metal elements which are not precious metals and oxidizing the metal alloy to produce a surface metal oxide layer that is conductive having a contact resistivity of 100 Ω-cm or less after the alloy has been subjected to 125°C for 1008 hours.

24. The process of claim 23 wherein the alloy produced has a mixed valance state.

25. The process of claim 23 wherein the provided alloy is a non conductive alloy.

26. The process of claim 23 wherein the alloy formed has a network of conductive veins in the oxide or a conductive oxide layer on the alloy.

27. The process of claim 23 wherein the oxidation step is performed by a thermal treatment of the alloy in an oxidizing atmosphere or a thermal treatment of the alloy in a reducing atmosphere, or treatment of the alloy with UV light or a treatment of the alloy with an electron beam or a treatment of the alloy with x-rays or a treatment of the alloy with microwaves or a treatment of the alloy with a chemical treatment in an oxidizing or reducing environment.

28. A bipolar plate for use in a fuel cell state comprising a metal alloy having at least two metal elements which are not precious metals, said alloy being capable of forming a surface metal oxide layer that is conductive having a resistivity less than or equal to 100 Ω-cm or less after the alloy has been subjected to 125°C for 1008 hours.

29. A method of forming a bipolar plate for use in a fuel cell assembly, comprising:
(a) forming a substrate blank of the bipolar plate from a conductive metal; and
(b) depositing a layer on at least one surface of the blank, the layer comprising a metal alloy comprising at least two metal elements which are not precious metals, said alloy being capable of forming a surface metal oxide layer that is conductive having a resistivity less than or equal to 100 Ω-cm or less after the alloy has been subjected to 125°C for 1008 hours.
